**Europäisches Patentamt**

**European Patent Office**

**Office européen des brevets**

(19)

(11) Veröffentlichungsnummer: **0 049 793**

**A2**

# (12) EUROPÄISCHE PATENTANMELDUNG

(21) Anmeldenummer: **81107666.0**

(22) Anmeldetag: **26.09.81**

(51) Int. Cl.³: **H 03 K 17/955**

(30) Priorität: **14.10.80 DE 3038692**

(43) Veröffentlichungstag der Anmeldung:
**21.04.82 Patentblatt 82/16**

(84) Benannte Vertragsstaaten:
**AT BE CH FR GB IT LI LU NL SE**

(71) Anmelder: **i f m electronic gmbh**
**Teichstrasse 4**
**D-4300 Essen 1(DE)**

(72) Erfinder: **Bittner, Wolfhard**
**Rosenstaffel 4**
**D-7992 Tettnang(DE)**

(72) Erfinder: **Czech, Ingo-Siegurd**
**Sandöschstrasse 33**
**D-7990 Friedrichshafen(DE)**

(72) Erfinder: **Hantsche, Gerhard**
**Joseph-Reiss-Strasse 7**
**D-7992 Tettnang(DE)**

(74) Vertreter: **Gesthuysen, Hans Dieter, Dipl.-Ing.**
**Huyssenallee 15**
**D-4300 Essen 1(DE)**

(54) **Elektronisches, berührungslos arbeitendes Schaltgerät.**

(57) Dargestellt und beschrieben ist ein elektronisches, berührungslos arbeitendes Schaltgerät (1), mit einem von außen kapazitiv beeinflußbaren Oszillator (10) und einem von dem Oszillator (10) vorzugsweise über einen Schaltverstärker (11) steuerbaren elektronischen Schalter (12), wobei der Oszillator (10) einen Verstärker mit mindestens einem Verstärkertransistor und mindestens einer Verstärkerlast und eine ohmisch-kapazitive Rückkopplungsschaltung (18) aufweist.

Um die erforderliche Betriebsspannung und den erforderlichen Betriebsstrom, primär die erforderliche Betriebsspannung, zu reduzieren, ist die Verstärkerlast als "aktive Last" ausgeführt. Insbesondere kann als Verstärkerlast, die als "aktive Last" ausgeführt ist, ein Lasttransistor vorgesehen sein. "Aktive Last" meint dabei ein elektronisches Bauelement (oder eine Schaltung mit aktiven elektronischen Bauelementen), das (bzw. die) in der Lage ist (bzw. sind), die im Stand der Technik als "ohm'sche Last" ausgeführte Verstärkerlast, üblicherweise als Arbeitswiderstand bezeichnet, so zu ersetzen, daß diese "aktive Last" eine praktisch der Betriebsspannung entsprechende Amplitude der Oszillatorausgangsspannung zuläßt, daß also an dieser "aktiven Last" der Spannungsabfall nicht auftritt, der an einer "ohm'schen Last" auftritt, - nämlich als Produkt aus Widerstand und Strom. "Atkive Last" meint also einen "Arbeitswiderstand", für den das ohm'sche Gesetz nicht gilt.

Fig.1

BEZEICHNUNG
siehe Titelseite

Die Erfindung betrifft ein elektronisches, berührungslos arbeitendes Schaltgerät, mit einem von außen kapazitiv beeinflußbaren Oszillator und einem
von dem Oszillator vorzugsweise über einen Schaltverstärker steuerbaren
elektronischen Schalter, wobei der Oszillator einen Verstärker mit mindestens einem Verstärkertransistor und mindestens einer Verstärkerlast und
eine ohmisch-kapazitive Rückkopplungsschaltung aufweist.

Elektronische, berührungslos arbeitende Schaltgeräte der in Rede stehenden
Art, sogenannte kapazitive Annäherungsschalter, sind vielfach bekannt.
Bei diesen Schaltgeräten gehört zu dem Oszillator eine kapazitiv wirkende
Ansprechelektrode (und zumeist auch eine der Ansprechelektrode zugeordnete Abschirmelektrode) und bewirkt eine Änderung der Kapazität zwischen
der Ansprechelektrode und Masse (bzw. eine Änderung der Kapazität zwischen
der Ansprechelektrode und der Abschirmelektrode und/oder eine Änderung der
Kapazität zwischen der Abschirmelektrode und Masse) den Schwingungseinsatz
bzw. den Schwingungsabriß des Oszillators. Der Übergang zwischen dem Zustand "Oszillator schwingt" und dem Zustand "Oszillator schwingt nicht" erfolgt stetig; Schwingungseinsatz und Schwingungsabriß sind also entsprechend
zu verstehen. Im Übergangsbereich zwischen dem Zustand "Oszillator schwingt"
und dem Zustand "Oszillator schwingt nicht" (und umgekehrt) ändert sich
also die Amplitude der Oszillatorausgangsspannung in Abhängigkeit von einer Abstandsänderung eines Beeinflussungskörpers am stärksten (Abstandsänderung eines Beeinflussungskörpers = Änderung des Abstandes zwischen einem
Beeinflussungskörper und der Ansprechelektrode). Die Änderung der Amplitude der Oszillatorausgangsspannung in Abhängigkeit von einer Änderung des
Abstandes zwischen einem Beeinflussungskörper und der Ansprechelektrode
ist die Empfindlichkeit des entsprechenden elektronischen Schaltgerätes.
Üblicherweise beträgt die zuvor erläuterte Empfindlichkeit etwa 0,5 V/mm;
die Amplitude der Oszillatorausgangsspannung ändert sich also um ca. 0,5 V,
wenn sich der Abstand zwischen einem Beeinflussungskörper und der Ansprechelektrode um 1 mm ändert.

Im Stand der Technik, von dem die Erfindung ausgeht, weist der Verstärker neben dem Verstärkertransistor mit der Verstärkerlast noch einen Ausgangstransistor mit einer Ausgangslast auf und sind sowohl die Verstärkerlast als auch die Ausgangslast als "ohm'sche Last" ausgeführt; die als "ohm'sche Last" ausgeführte Verstärkerlast und die als "ohm'sche Last" ausgeführte Ausgangslast werden üblicherweise als Arbeitswiderstand des Verstärkertransistors bzw. als Arbeitswiderstand des Ausgangstransistors bezeichnet.

Bei den elektronischen Schaltgeräten der eingangs beschriebenen und zuvor hinsichtlich des Aufbaus ihres Oszillators noch näher erläuterten Art benötigt der Oszillator eine Betriebsspannung von knapp 10 V und einen Betriebsstrom von knapp 0,5 mA, um die weiter oben erläuterte Empfindlichkeit von 0,5 V/mm zu erreichen. Das ist insbesondere dann nicht optimal, wenn solche Schaltgeräte als Zweileitergeräte ausgeführt sind, also insgesamt nur zwei Anschlußleiter aufweisen, mit denen sie einerseits an eine Spannungsquelle und andererseits an einen Verbraucher, also an eine Last, angeschlossen werden. Elektronische Schaltgeräte der in Rede stehenden Art sollen nämlich insbesondere dann, wenn sie als Zweileitergeräte ausgeführt sind, eine möglichst geringe Betriebsspannung und einen möglichst geringen Betriebsstrom haben, - damit sie insoweit elektrischen, kontaktbehafteten Schaltgeräten möglichst nahe kommen, - die ja eine Betriebsspannung und einen Betriebsstrom nicht benötigen.

Der Erfindung liegt folglich die Aufgabe zugrunde, das in Rede stehende elektronische, berührungslos arbeitende Schaltgerät in bezug auf die erforderliche Betriebsspannung und auf den erforderlichen Betriebsstrom, primär in bezug auf die erforderliche Betriebsspannung, zu verbessern.

Das erfindungsgemäße elektronische, berührungslos arbeitende Schaltgerät, bei dem die zuvor aufgezeigte Aufgabe gelöst ist, ist zunächst und im wesentlichen dadurch gekennzeichnet, daß die Verstärkerlast als "aktive Last" ausgeführt ist. Insbesondere kann als Verstärkerlast, die als "aktive Last" ausgeführt ist, ein Lasttransistor vorgesehen sein. "Aktive Last" meint dabei ein aktives elektronisches Bauelement (oder eine Schaltung mit

0049793

Gesthuysen & Leutwein

aktiven elektronischen Bauelementen), das (bzw. die) in der Lage ist (bzw. sind), die im Stand der Technik als "ohm'sche Last" ausgeführte Verstärkerlast, üblicherweise als Arbeitswiderstand bezeichnet, so zu ersetzen, daß diese "aktive Last" eine praktisch der Betriebsspannung entsprechende Amplitude der Oszillatorausgangsspannung zuläßt, daß also an dieser "aktiven Last" der Spannungsabfall nicht auftritt, der an einer "ohm'schen Last" auftritt, - nämlich als Produkt aus Widerstand und Strom. "Aktive Last" meint also einen "Arbeitswiderstand", für den das ohm'sche Gesetz nicht gilt.

Dadurch, daß bei dem erfindungsgemäßen elektronischen Schaltgerät die Verstärkerlast als "aktive Last" ausgeführt ist, ist ein hoher Verstärkungsfaktor bei relativ niedriger Betriebsspannung und relativ niedrigem Betriebsstrom möglich. Unter Beibehaltung einer Empfindlichkeit von 0,5 V/mm benötigt der Oszillator des erfindungsgemäßen elektronischen Schaltgerätes nur eine Betriebsspannung von knapp 3 V und nur einen Betriebsstrom von ca. 0,2 mA!

Im einzelnen gibt es verschiedene Möglichkeiten, das erfindungsgemäße elektronische Schaltgerät auszugestalten und weiterzubilden, was im folgenden nur beispielhaft dargelegt werden soll.

Nach einer weiteren Lehre der Erfindung, der auch losgelöst von der zuvor erläuterten Lehre der Erfindung besondere und damit erfinderische Bedeutung zukommt, ist der Verstärker als Differenzverstärker ausgeführt, weist der Verstärker also mindestens zwei Verstärkertransistoren mit jeweils einer als "aktive Last" ausgeführten Verstärkerlast auf. Während im Stand der Technik, von dem die Erfindung ausgeht, der Verstärker des Oszillators unsymmetrisch ausgeführt ist, ist bei der zuvor beschriebenen besonders bevorzugten Ausführungsform des erfindungsgemäßen elektronischen Schaltgerätes der Verstärker des Oszillators - als Differenzverstärker - symmetrisch ausgeführt. Dadurch ist die Empfindlichkeit des in Rede stehenden elektronischen Schaltgerätes in bezug auf sogenannte Netz-Brummstörungen stark reduziert!

- -

Bei der zuvor beschriebenen Ausführungsform des erfindungsgemäßen elektronischen Schaltgerätes, bei der der Verstärker als Differenzverstärker ausgeführt ist, empfiehlt es sich, die beiden jeweils als "aktive Last" ausgeführten Verstärkerlasten zu einer Stromspiegelschaltung zusammenzuschalten, wobei der die Verstärkerlast des nicht den Ausgang des Differenzverstärkers bildenden Verstärkertransistors darstellende Lasttransistor als Diode geschaltet sein kann.

Eingangs ist bei der Beschreibung des elektronischen, berührungslos arbeitenden Schaltgerätes, von dem die Erfindung ausgeht, gesagt worden, daß dabei der Verstärker neben dem Verstärkertransistor noch einen Ausgangstransistor aufweist. Das kann auch bei dem erfindungsgemäßen elektronischen Schaltgerät der Fall sein. Dann empfiehlt es sich, die Ausgangslast des Ausgangstransistors als "aktive Last" auszuführen, also in gleicher Weise auszuführen, wie erfindungsgemäß die Verstärkerlast des Verstärkertransistors ausgeführt ist bzw. die Verstärkerlasten der Verstärkertransistoren ausgeführt sind.

Nach einer weiteren Lehre der Erfindung, der wiederum erhebliche Bedeutung zukommt, ist das erfindungsgemäße elektronische, berührungslos arbeitende Schaltgerät ergänzend dadurch gekennzeichnet, daß der Verstärker einen Konstantstromgenerator aufweist und der Konstantstromgenerator in Reihe zu dem Verstärkertransistor bzw. zu den Verstärkertransistoren geschaltet ist. Vorzugsweise ist dabei als Konstantstromgenerator der zweite Stromspiegeltransistor einer Stromspiegelschaltung verwendet und ist der erste Stromspiegeltransistor der Stromspiegelschaltung als Diode geschaltet und in Reihe mit einem Generatorwiderstand an eine Konstantspannungsquelle angeschlossen.

Im folgenden wird die Erfindung anhand einer lediglich ein Ausführungsbeispiel darstellenden Zeichnung näher erläutert, wobei auch weitere, zuvor noch nicht dargelegte Lehren der Erfindung aufgezeigt werden; es zeigt

Fig. 1    das Blockschaltbild eines erfindungsgemäßen elektronischen, berührungslos arbeitenden Schaltgerätes und

Fig. 2       eine bevorzugte Ausführungsform des Oszillators des elektronischen Schaltgerätes nach Fig. 1.

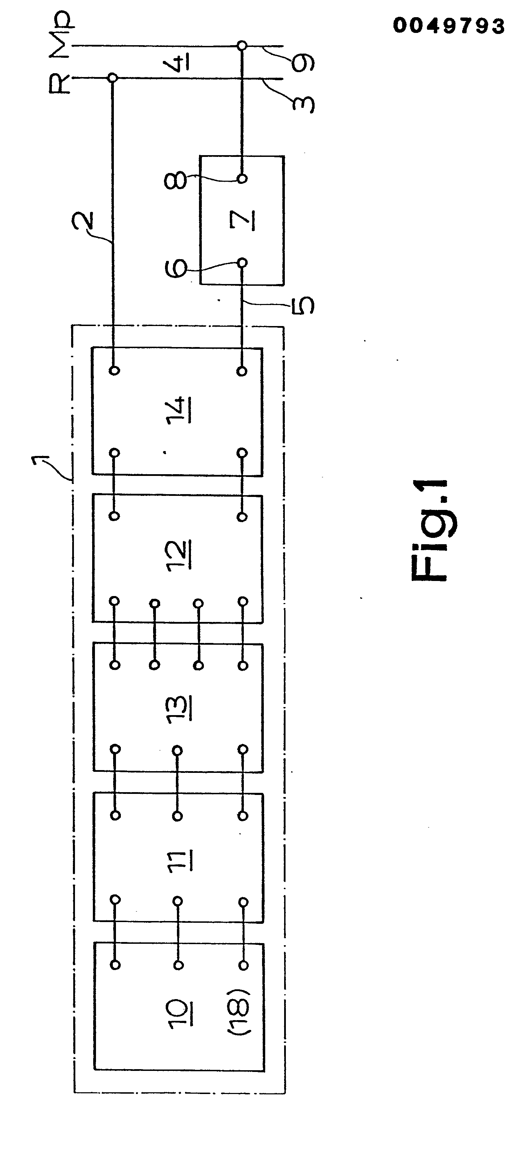

Das in Fig. 1 durch ein Blockschaltbild dargestellte elektronische Schaltgerät 1 arbeitet berührungslos, d. h. es spricht auf einen sich annähernden,
in Fig. 1 nicht dargestellten Beeinflussungskörper an, und ist über einen
weiteren Außenleiter 5 mit einem Anschluß 6 eines Verbrauchers 7 verbindbar; der andere Anschluß 8 des Verbrauchers 7 ist an den anderen Pol 9 der
Spannungsquelle 4 angeschlossen. Mit anderen Worten ist das dargestellte
elektronische Schaltgerät 1 über insgesamt nur zwei Außenleiter 2, 5 einerseits an die Spannungsquelle 4 und andererseits an den Verbraucher 7 anschließbar.

In seinem grundsätzlichen Aufbau besteht das in Fig. 1 dargestellte elektronische, d. h. kontaktlose Schaltgerät 1 aus einem von außen, nämlich
durch den nicht dargestellten Beeinflussungskörper, kapazitiv beeinflußbaren Oszillator 10, einem von dem Oszillator 10 über einen Schaltverstärker 11 steuerbaren elektronischen Schalter 12, z. B. einem Transistor,
einem Thyristor oder einem Triac, und aus einer Speiseschaltung 13 zur Erzeugung der Betriebsspannung für den Oszillator 10 und den Schaltverstärker 11. Im dargestellten Ausführungsbeispiel ist eingangsseitig noch eine
Gleichrichterbrücke 14 vorgesehen, da die Spannungsquelle 4 Wechselspannung
führt.

Wie die Figuren zeigen, weist der Oszillator 10 einen Verstärker 15 mit zwei
Verstärkertransistoren 16 und zwei Verstärkerlasten 17 sowie eine ohmisch-
kapazitive Rückkopplungsschaltung 18 auf; der Oszillator 10 ist also als
RC-Oszillator ausgeführt.

Erfindungsgemäß ist jede Verstärkerlast 17 als "aktive Last" ausgeführt,
ist nämlich im dargestellten Ausführungsbeispiel als Verstärkerlast 17 jeweils ein Lasttransistor vorgesehen.

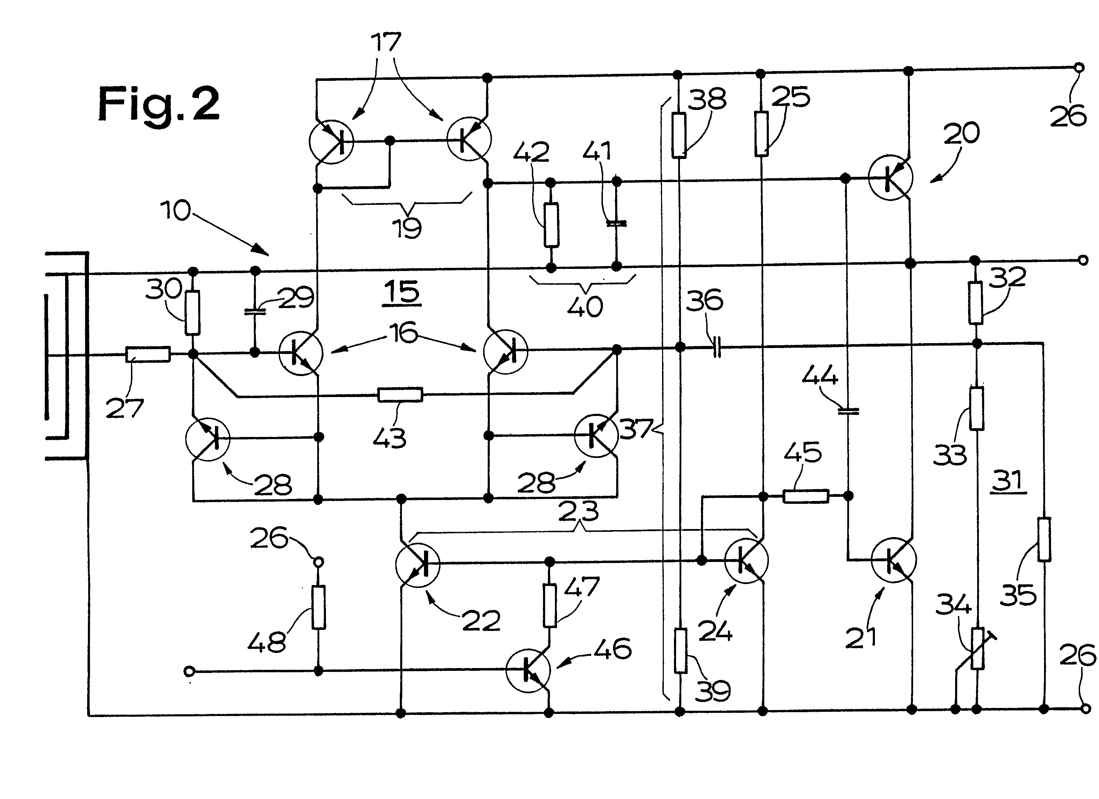

Die Fig. 2 zeigt insoweit eine bevorzugte Ausführungsform des erfindungsgemäßen elektronischen Schaltgerätes 1, als der Verstärker 15 des Oszillators 10 als Differenzverstärker ausgeführt ist, also in üblicher Konfiguration zwei Verstärkertransistoren 16 mit jeweils einer als "aktive Last" ausgeführten Verstärkerlast 17 aufweist. Dabei sind die beiden jeweils als "aktive Last" ausgeführten Verstärkerlasten 17 zu einer Stromspiegelschaltung 19 zusammengeschaltet, wobei der die Verstärkerlast 17 des nicht den Ausgang des Differenzverstärkers bildenden Verstärkertransistors 16 darstellende Lasttransistor als Diode geschaltet ist.

In dem Ausführungsbeispiel, das die Fig. 2 zeigt, weist der Verstärker 15 des Oszillators 10 einen vom Ausgang des den Ausgang des Differenzverstärkers bildenden Verstärkertransistors 16 angesteuerten Ausgangstransistor 20 und eine Ausgangslast 21 auf. Dabei ist die Ausgangslast 21 des Ausgangstransistors 20 als "aktive Last" ausgeführt, wie auch die Verstärkerlasten 17 der Verstärkertransistoren 16 jeweils als "aktive Last" ausgeführt sind.

Im übrigen zeigt die Fig. 2, daß der Verstärker 15 des Oszillators 10 einen Konstantstromgenerator 22 aufweist und der Konstantstromgenerator 22 in Reihe zu den Verstärkertransistoren 16 geschaltet ist. Als Konstantstromgenerator 22 ist der zweite Stromspiegeltransistor einer Stromspiegelschaltung 23 verwendet, deren erster Stromspiegeltransistor 24 als Diode geschaltet und in Reihe mit einem Generatorwiderstand 25 an eine Konstantspannungsquelle 26 angeschlossen ist.

Im übrigen ist bei der in Fig. 2 dargestellten bevorzugten Ausführungsform des Oszillators 10 des erfindungsgemäßen elektronischen Schaltgerätes 1 noch folgendes verwirklicht:

Zunächst ist der Basis des Verstärkertransistors 16, die den invertierenden Eingang des Differenzverstärkers darstellt, ein Schutzwiderstand 27 vorgeschaltet und ist jeder Basis-Emitter-Strecke der Verstärkertransistoren 16 eine Schutzdiode 28, nämlich ein als Diode geschalteter Schutztransistor, parallel geschaltet.

Zu dem Oszillator 10 des erfindungsgemäßen elektronischen Schaltgerätes gehört neben dem zuvor im einzelnen erläuterten Verstärker 15 die ohmisch-kapazitive Rückkopplungsschaltung 18, zu der im dargestellten Ausführungsbeispiel eine Gegenkopplungskapazität 29 und ein Gegenkopplungswiderstand 30 sowie ein Mitkopplungswiderstandsnetzwerk 31 (mit Netzwerkwiderständen 32, 33, 34, 35) und eine Mitkopplungskapazität 36 gehören.

Um den Gleichspannungsarbeitspunkt des Oszillators 10 zu fixieren, ist ein Spannungsteiler 37 mit Spannungsteilerwiderständen 38, 39 vorgesehen, wobei die Spannungsteilerwiderstände 38 und 39 den gleichen Widerstandswert haben.

Zwischen der Basis und dem Kollektor des Ausgangstransistors 20 ist ein den Oszillator 10 stabilisierendes Stabilisierungsnetzwerk 40 mit einer Netzwerkkapazität 41 und einem Netzwerkwiderstand 42 vorgesehen.

Die Basen der Verstärkertransistoren 16 sind über einen Ausgleichswiderstand 43 miteinander verbunden. Dadurch ist die Amplitude der Oszillatorausgangsspannung relativ unabhängig von Schwankungen der Betriebsspannung, d. h. von Schwankungen der Konstantspannungsquelle 26.

Im übrigen ist die als "aktive Last" ausgeführte Ausgangslast 21 des Ausgangstransistors 20 über eine an die Basis des Ausgangstransistors 20 angeschlossene Ansteuerkapazität 44 und einen an den Generatorwiderstand 25 angeschlossenen Ansteuerwiderstand 45 angesteuert.

Schließlich zeigt die Fig. 2 noch, daß die dargestellte Ausführungsform des Oszillators 10 des erfindungsgemäßen elektronischen Schaltgerätes 1 einen Hysteresetransistor 46 mit zwei Hysteresewiderständen 47, 48 aufweist.

**0049793**

Patentansprüche:

1. Elektronisches, berührungslos arbeitendes Schaltgerät, mit einem von außen kapazitiv beeinflußbaren Oszillator und einem von dem Oszillator vorzugsweise über einen Schaltverstärker steuerbaren elektronischen Schalter, wobei der Oszillator einen Verstärker mit mindestens einem Verstärkertransistor und mindestens einer Verstärkerlast und eine ohmisch-kapazitive Rückkopplungsschaltung aufweist, d a d u r c h   g e k e n n z e i c h n e t, daß die Verstärkerlast (17) als "aktive Last" ausgeführt ist.

2. Elektronisches Schaltgerät nach Anspruch 1, dadurch gekennzeichnet, daß als als "aktive Last" ausgeführte Verstärkerlast (17) ein Lasttransistor vorgesehen ist.

3. Elektronisches Schaltgerät nach Anspruch 1 oder 2, dadurch gekennzeichnet, daß der Verstärker (15) als Differenzverstärker ausgeführt ist, also mindestens zwei Verstärkertransistoren (16) mit jeweils einer als "aktive Last" ausgeführten Verstärkerlast (17) aufweist.

4. Elektronisches Schaltgerät nach Anspruch 2 und 3, dadurch gekennzeichnet, daß die beiden jeweils als "aktive Last" ausgeführten Verstärkerlasten (17) zu einer Stromspiegelschaltung (19) zusammengeschaltet sind.

5. Elektronisches Schaltgerät nach Anspruch 4, dadurch gekennzeichnet, daß der die Verstärkerlast (17) des nicht den Ausgang des Differenzverstärkers bildenden Verstärkertransistors (16) darstellende Lasttransistor als Diode geschaltet ist.

6. Elektronisches Schaltgerät nach einem der Ansprüche 1 bis 5, dadurch gekennzeichnet, daß der Verstärker (15) einem vom Ausgang des Verstärkertransistors bzw. vom Ausgang des den Ausgang des Differenzverstärkers bildenden Verstärkertransistors (16) angesteuerten Ausgangstransistors (20) und eine Ausgangslast (21) aufweist.

7. Elektronisches Schaltgerät nach Anspruch 6, dadurch gekennzeichnet, daß die Ausgangslast (21) des Ausgangstransistors (20) als "aktive Last" ausgeführt ist.

8. Elektronisches Schaltgerät nach einem der Ansprüche 1 bis 7, dadurch gekennzeichnet, daß der Verstärker (10) einen Konstantstromgenerator (22) aufweist und der Konstantstromgenerator (22) in Reihe zu dem Verstärkertransistor bzw. zu den Verstärkertransistoren (16) geschaltet ist.

9. Elektronisches Schaltgerät nach Anspruch 8, dadurch gekennzeichnet, daß als Konstantstromgenerator (22) der zweite Stromspiegeltransistor einer Stromspiegelschaltung (23) verwendet ist und der erste Stromspiegeltransistor (24) der Stromspiegelschaltung(23) als Diode geschaltet und in Reihe mit einem Generatorwiderstand (25) an eine Konstantspannungsquelle (26) angeschlossen ist.

10. Elektronisches Schaltgerät nach einem der Ansprüche 1 bis 9, dadurch gekennzeichnet, daß der Basis des Verstärkertransistors bzw. der Basis des Verstärkertransistors (16), die den invertierenden Eingang des Differenzverstärkers darstellt, ein Schutzwiderstand (27) vorgeschaltet ist.

11. Elektronisches Schaltgerät nach einem der Ansprüche 1 bis 10, dadurch gekennzeichnet, daß der Basis-Emitter-Strecke des Verstärkertransistors bzw. jeder Basis-Emitter-Strecke der Verstärkertransistoren (16) eine Schutzdiode (28), vorzugsweise ein als Diode geschalteter Schutztransistor, parallel geschaltet ist.

Fig.1

0049793

Fig.2

0049793